(19) Europäisches Patentamt
European Patent Office
Office européen des brevets

(11) **EP 2 717 303 A1**

(12) **EUROPEAN PATENT APPLICATION**
published in accordance with Art. 153(4) EPC

(43) Date of publication:
09.04.2014 Bulletin 2014/15

(51) Int Cl.:
*H01L 21/52* [(2006.01)]   *B23K 1/00* [(2006.01)]
*B23K 1/20* [(2006.01)]   *B23K 35/14* [(2006.01)]
*B23K 35/26* [(2006.01)]   *C22C 12/00* [(2006.01)]
*H01L 23/34* [(2006.01)]

(21) Application number: 12793525.2

(22) Date of filing: 22.05.2012

(86) International application number:
PCT/JP2012/003318

(87) International publication number:
WO 2012/164865 (06.12.2012 Gazette 2012/49)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 03.06.2011 JP 2011125656

(71) Applicant: Panasonic Corporation
Osaka 571-8501 (JP)

(72) Inventors:
• NAKAMURA, Taichi
Osaka 540-6207 (JP)
• KITAURA, Hidetoshi
Osaka 540-6207 (JP)
• YOSHIZAWA, Akihiro
Kobe-shi
Hyogo 652-0806 (JP)

(74) Representative: Grünecker, Kinkeldey,
Stockmair & Schwanhäusser
Leopoldstrasse 4
80802 München (DE)

(54) **BONDED STRUCTURE**

(57) A bonded structure 106 includes a semiconductor element 102 bonded to a Cu electrode 103 with a bonding material 104 predominantly composed of Bi, wherein the semiconductor element 102 and the Cu electrode 103 are bonded to each other via a laminated body 209a that progressively increases a Young's modulus from the bonding material 104 to a bonded material (the semiconductor element 102 and the Cu electrode 103), achieving stress relaxation against a thermal stress generated in a temperature cycle during the use of a power semiconductor module.

FIG. 2C

- 102 SEMICONDUCTOR ELEMENT
- 204 BARRIER METAL LAYER
- 207 FIRST INTERMEDIATE LAYER
- 104 BONDING MATERIAL
- 206 SECOND INTERMEDIATE LAYER
- 209a LAMINATED BODY
- 208 BONDED SECTION
- 201 Ag LAYER
- 202 ELECTRODE SURFACE-TREATED LAYER
- 103 Cu ELECOTRODE

**Description**

Technical Field

The present invention relates to the internal bonded section of a semiconductor component and particularly relates to a bonded structure that joins a semiconductor element and an electrode of a power semiconductor module with Bi solder, the power semiconductor module requiring excellent mechanical characteristics and high heat resistance.

Background Art

Conventionally, Sn-Pb eutectic solder has been frequently used in the field of electronics packaging. However, lead-free bonded sections have been recently demanded because of increasing concern about the harmfulness of lead and growing interest in the environment.
For this reason, substitute materials have been developed and put into practical use for Sn-Pb eutectic solder that is a typical solder material.
For internal bonded sections of semiconductor components, substitute materials of high-temperature lead solder have been examined.
Such substitute solder materials include Au, Zn, Sn, and Bi materials. Of these materials, some Au solder materials including an Au-20wt%Sn material having a melting point of 280°C have been practically used. Since the major component of the materials is Au, the materials are not generally used because of its hardness as a material property, its high material cost, and its limited use for small components.
Zn solder materials having high corrosiveness and an extremely high modulus of elasticity need to have improved mechanical characteristics when being applied to the internal bonded sections of semiconductor components.
Sn solder materials have excellent mechanical characteristics but have a melting point lower than 250°C and low heat resistance. Thus, in order to improve the heat resistance of Sn solder materials, for example, SnCu compounds are formed to obtain bonding materials that are melted at higher temperatures because of their intermetallic compounds. Such bonding materials have been examined. However, solidification shrinkage of an intermetallic compound causes a gap during bonding, requiring improvement of mechanical characteristics and heat release characteristics.
For these reasons, Bi solder materials that melt around 270°C have been examined as potential substitute materials of high-temperature lead solder.
For example, Patent Literature 1 discloses an example of a Bi solder material used as a bonding material.
FIG. 8 is a cross-sectional view of a conventional bonded structure described in Patent Literature 1. A power semiconductor module 401 has a bonded section 404 between a power semiconductor element 402 and an electrode 403. The bonded section 404 is made of a Bi-Ag solder material containing 15 wt% to 60 wt% of Ag.
However, if the operating temperature of the power semiconductor element 402 is 150°C like Si, the Bi-Ag solder material described in Patent Literature 1 has connection reliability. If the operating temperature of the power semiconductor element 402 is 175°C or 200°C that is higher than that of Si like those of GaN and SiC, the Bi-Ag solder material described in Patent Literature 1 may cause cracks or peeling on the bonded section 404.
Cracks or peeling may occur on the bonded section 404 because the Bi-Ag solder material cannot sufficiently relax a thermal stress determined by a difference between the thermal expansion coefficient ($\alpha \approx 3$ ppm/K) of the power semiconductor element 402 and the linear expansion coefficient ($\alpha \approx 18$ ppm/K) of the Cu electrode 403.
Thus, in the bonded structure using the Bi-Ag solder material of Patent Literature 1, if the operating temperature of the power semiconductor element 402 is higher than 150°C, higher stress relaxation is necessary for a high-temperature range.
Patent Literature 2 discloses prevention of cracks and peeling in a bonded structure.
In Patent Literature 2, a protective resin covering a semiconductor element is also formed over an outer region between the intermediate bonded layer and the solder bonded layer of the semiconductor element. This can improve resistance to cracks in the semiconductor element and reduce a thermal stress applied to an interface between the semiconductor element and a solder material and an interface between the solder material and an electrode.

Citation List

Patent Literatures

Patent Literature 1: Japanese Patent Laid-Open No. 2006-310507
Patent Literature 2: Japanese Patent Laid-Open No. 2011-023631

Summary of Invention

Technical Problem

In Patent Literature 2, the protective resin is applied over a predetermined area to improve the stress relaxation of the bonded structure that includes the semiconductor element and the electrode with the solder material interposed between the semiconductor element and the electrode. A technical object of the present invention is to improve stress relaxation so as to prevent cracks and peeling on a bonded section in the bonded structure of a power semiconductor module by a solution different from that of the invention described in Patent Literature 2.

Solution to Problem

The present inventors have reached an idea of effectively relaxing and absorbing a thermal stress based on a difference in thermal expansion coefficient between bonded materials (a semiconductor element and a Cu electrode) by forming a laminated structure that progressively changes a strain relative to an external stress from a bonding material to the bonded material (the semiconductor element and the Cu electrode), thereby completing the present invention.
A first aspect of the present invention is a bonded structure including a semiconductor element bonded to a Cu electrode with a bonding material predominantly composed of Bi, wherein the bonding material and an intermediate layer formed on a surface of the bonding material constitute a laminated body, Cu on a surface of the semiconductor element is bonded to the Cu electrode via the laminated body, and the laminated body is configured for the semiconductor element and the Cu electrode such that Young's moduli E1 to E4 satisfy at least one of the following conditions (p1) and (q1) :

$$E3 < E2 < E1 \ldots (p1)$$

$$E3 < E2 < E4 \ldots (q1)$$

where E1 is the Young's modulus of Cu on the surface of the semiconductor element, E2 is the Young's modulus of the intermediate layer, E3 is the Young's modulus of the bonding material, and E4 is the Young's modulus of the Cu electrode.
A second aspect of the present invention, in the first aspect, is a bonded structure in which the laminated body is a three-layer laminated body including the bonding material and two intermediate layers formed on the top and bottom of the bonding material, and the three-layer laminated body is configured for the semiconductor element and the Cu electrode such that the Young's moduli E1, E3, and E4 and Young's moduli E21 and E24 satisfy at least one of the following conditions (p2) and (q2) :

$$E3 < E21 < E1 \ldots (p2)$$

$$E3 < E24 < E4 \ldots (q2)$$

where E21 is the Young's modulus of the first intermediate layer near the semiconductor element and E24 is the Young's modulus of the second intermediate layer near the Cu electrode.
A third aspect of the present invention, in the first aspect, is a bonded structure in which the laminated body is a two-layer laminated body including the bonding material and an intermediate layer formed on the bonding material and near the semiconductor element, and the two-layer laminated body is configured for the semiconductor element and the Cu electrode such that the Young's moduli E1 and E3 and a Young's modulus E21 satisfy the following condition (p2):

$$E3 < E21 < E1 \ldots (p2)$$

where E21 is the Young's modulus of the intermediate layer near the semiconductor element.
A fourth aspect of the present invention, in the first aspect, is a bonded structure in which the laminated body is a two-layer laminated body including the bonding material and an intermediate layer formed on the bonding material and near the Cu electrode, and the two-layer laminated body is configured for the semiconductor element and the Cu electrode such that the Young's moduli E3 and E4 and a Young's modulus E24 satisfy the following condition (q2):

$$E3 < E24 < E4 \ ... \ (q2)$$

where E24 is the Young's modulus of the intermediate layer.

A fifth aspect of the present invention, in any one of the first to fourth aspects, is a bonded structure including the intermediate layer made of at least one metal selected from the group consisting of an AuSn compound, an AgSn compound, a CuSn compound, Au, and Ag.

A sixth aspect of the present invention, in any one of the first to fifth aspects, is a bonded structure including the intermediate layer made of a CuSn compound.

Advantageous Effects of Invention

According to the present invention, a semiconductor element and a Cu electrode are bonded to each other via a laminated structure that progressively increases a Young's modulus from a bonding material to a bonded material, thereby exerting a so-called spring effect with an excellent stress relaxing function against a thermal stress generated in a temperature cycle during the use of a power semiconductor module. Thus, the semiconductor element and the electrode can be bonded to each other with high quality so as to improve bonding reliability.

Brief Description of Drawings

[FIG. 1] FIG. 1 is a cross-sectional view of a mounting structure including a bonded structure as a constituent element.
[FIG. 2A] FIG. 2A is a manufacturing process drawing of a bonded structure according to a second embodiment of the present invention.
[FIG. 2B] FIG. 2B is a manufacturing process drawing of the bonded structure according to the second embodiment of the present invention.
[FIG. 2C] FIG. 2C is a manufacturing process drawing of the bonded structure according to the second embodiment of the present invention.
[FIG. 3] FIG. 3 is a structural diagram of a bonded structure according to a third embodiment of the present invention.
[FIG. 4] FIG. 4 is a structural diagram of a bonded structure according to a fourth embodiment of the present invention.
[FIG. 5] FIG. 5 is an enlarged cross-sectional view of the mounting structure.
[FIG. 6] FIG. 6 is a chart of the configurations and thicknesses of an electrode surface-treated layer and a Bi underlying layer before bonding and the compositions and thicknesses of a second intermediate layer and a first intermediate layer after bonding in Examples 1 to 15 according to the embodiments of the present invention.
[FIG. 7] FIG. 7 is a chart showing the yield test results of the bonded structure.

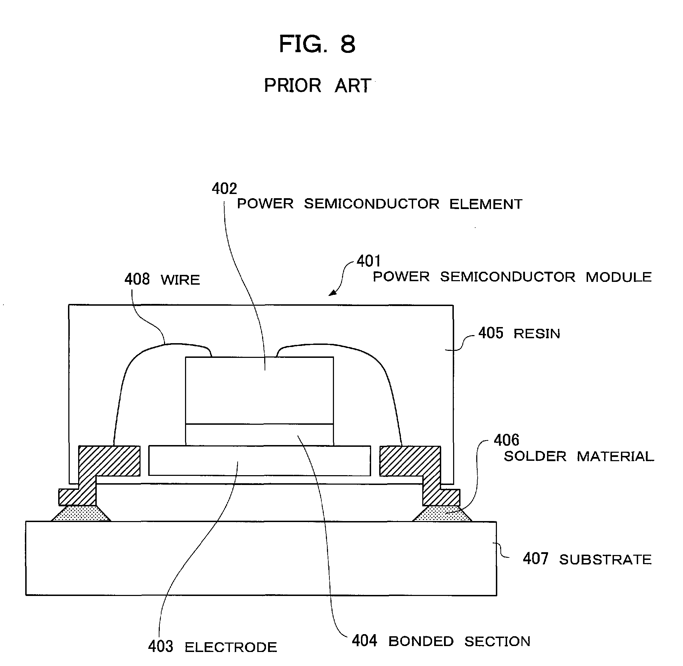

[FIG. 8] FIG. 8 is an enlarged cross-sectional view of a mounting structure according to the related art.

Description of Embodiments

An invention described in a first embodiment is a bonded structure including a semiconductor element bonded to a Cu electrode with a bonding material predominantly composed of Bi, wherein the bonding material and an intermediate layer formed on a surface of the bonding material constitute a laminated body, Cu on a surface of the semiconductor element is bonded to the Cu electrode via the laminated body, and Young's moduli are sequentially increased in one direction of the bonding material, the intermediate layer, and the semiconductor element or in one direction of the bonding material, the intermediate layer, and the Cu electrode or the Young's moduli are sequentially increased toward the semiconductor element and the Cu electrode from the bonding material through the intermediate layer.

This configuration is simply described below: in the bonded structure, the laminated body is configured for the semiconductor element and the Cu electrode such that Young's moduli E1 to E4 satisfy at least one of the following conditions (p1) and (q1) :

$$E3 < E2 < E1 \ ... \ (p1)$$

$$E3 < E2 < E4 \ldots (q1)$$

where E1 is the Young's modulus of Cu on the surface of the semiconductor element, E2 is the Young's modulus of the intermediate layer, E3 is the Young's modulus of the bonding material, and E4 is the Young's modulus of the Cu electrode.

Inventions described in the following second to fourth embodiments are the subordinate concepts of the invention described in the first embodiment. The invention according to the second embodiment includes an intermediate layer formed on each surface of the bonding material, a laminated body of three layers (the intermediate layer, the bonding material, and the intermediate layer) is disposed between a semiconductor element and a Cu electrode, and Young's moduli are sequentially increased toward the surfaces of the semiconductor element and the Cu electrode from the bonding material through the intermediate layer so as to relax a stress.

The invention according to the third embodiment has a two-layer laminated body (the intermediate layer and the bonding material) including the intermediate layer formed on one surface of the bonding material so as to face the semiconductor element, and Young's moduli are sequentially increased toward the bonding material, the intermediate layer, and the semiconductor element so as to relax a stress.

The invention according to the fourth embodiment has a two-layer laminated body (the intermediate layer and the bonding material) including the intermediate layer formed on one surface of the bonding material and near the Cu electrode, and Young's moduli are sequentially increased so as to relax a stress as in the invention according to the third embodiment.

In the inventions according to the embodiments, copper as a material of the electrode or the bottom layer of a barrier metal layer, which will be described later, is a concept including copper and a copper alloy.

The inventions according to the embodiments will be described below with reference to the accompanying drawings.

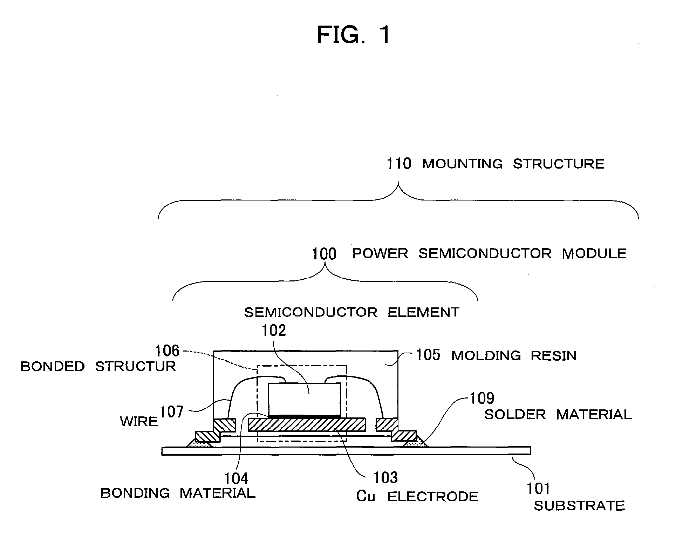

FIG. 1 is a cross-sectional view of a mounting structure including, as a constituent element, a bonded structure according to the inventions described in the embodiments.

First, a semiconductor element 102 and a Cu electrode 103 are bonded to each other with a bonding material 104 to form a bonded structure 106, the bonded structure 106 is then sealed with a molding resin 105 to form a power semiconductor module 100, and finally, the power semiconductor module 100 is mounted on a substrate 101 with a solder material 109 to form a mounting structure 110.

The bonded structure 106 will be specifically described below.

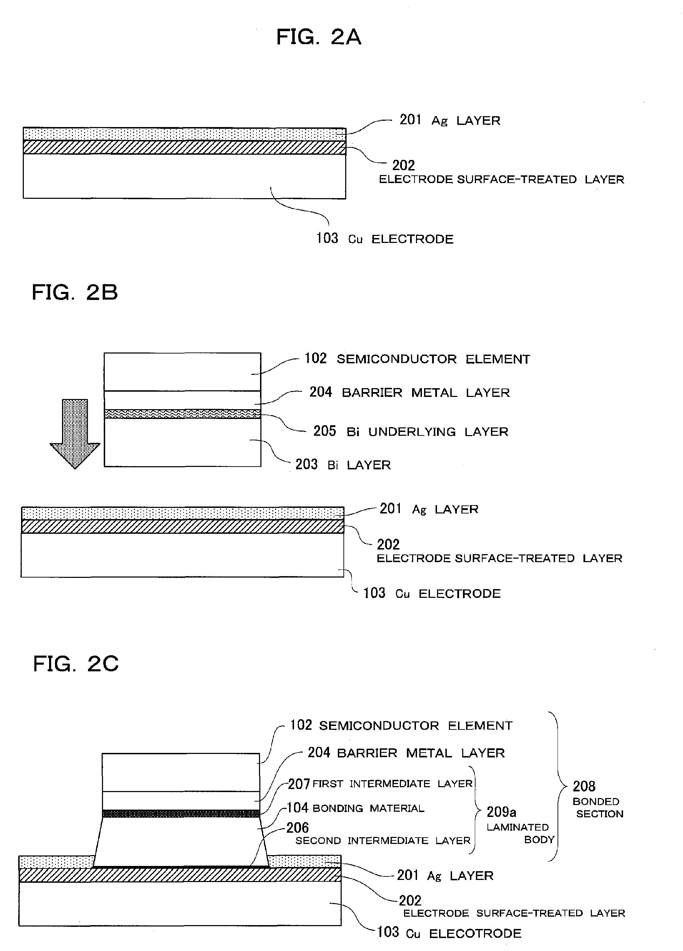

FIGS. 2A, 2B, and 2C are manufacturing process drawings of the bonded structure 106. In the following explanation, as shown in FIG. 2C, a second intermediate layer 206 is formed under the bonding material 104 and a first intermediate layer 207 is formed on the bonding material 104. In other words, a three-layer laminated body 209a is provided.

FIG. 2A is a process drawing for supplying the Cu electrode 103.

The Cu electrode 103 is supplied in a nitrogen atmosphere (room temperature) containing 5% of hydrogen. On the Cu electrode 103 composed of a Cu alloy, an Ag layer 201 and an electrode surface-treated layer 202 are formed beforehand as surface-treated layers by electroplating.

FIG. 2B is a process drawing for placing the semiconductor element 102, which has a Bi layer 203, on the Ag layer 201 that is a surface-treated layer of the Cu electrode 103.

When the semiconductor element 102 is placed, the Cu electrode 103 is heated to 320°C in a nitrogen atmosphere containing 5% of hydrogen.

On the semiconductor element 102 which is composed of GaN and has a thickness of 0.3 mm and a size of 4 mm × 5 mm, a barrier metal layer 204, which includes multiple layers of 0.1-$\mu$m Cr/1-$\mu$m Ni/3-$\mu$m Cu in this order from the semiconductor element 102, and a Bi underlying layer 205 are formed beforehand by an evaporation method, and then the Bi layer 203 containing Bi with a thickness of 10 $\mu$m is formed on the Bi underlying layer 205 by electroplating.

For the barrier metal layer 204, Cr near the semiconductor element 102 is deposited to ensure continuity with Si by ohmic bonding.

Ni of the barrier metal layer 204 is deposited to prevent a device function from being deteriorated by the diffusion of Cu components to the device of the semiconductor element. In other words, Ni is deposited to prevent the diffusion of Cu.

Cu of the barrier metal layer 204 forms a layer in contact with the Bi underlying layer 205. The Cu layer is provided for the following reason: Bi and Ni of the Bi layer 203 form an intermetallic compound $Bi_3Ni$ on an interface, and the fragile metallic compound layer may become a starting point of a crack when being deformed by a thermal stress, for example, during the use of the power semiconductor module. Thus, Cu is deposited between Bi and Ni of the barrier metal layer to prevent Bi from being diffused to Ni.

Cu is selected because of its small dissolution amount (about 0.4 at%) against Bi and thus a barrier effect is exerted to prevent the diffusion of Bi. Although Cu having a thickness of at least 1 $\mu$m can prevent the diffusion of Bi, the Cu thickness is set at 3 μm in consideration of a thickness difference of 2 μm in electroplating.

The semiconductor element 102 is placed with a load of about 50 gf to 150 gf on the Cu electrode 103 such that the Bi layer 203 is in contact with the Ag layer 201 that is a surface-treated layer of the Cu electrode 103.

In the examples of the present invention, the semiconductor element 102 is placed with a load of 60 gf on the Cu electrode 103. The examples will be described later.

FIG. 2C is a process drawing for solidifying the bonding material 104 by self-cooling in a state in which the Ag layer 201 is partially diffused into the molten Bi layer 203. In the process of FIG. 2C, the bonding material 104 is self-cooled in a nitrogen atmosphere containing 5% of hydrogen. The solidification of the bonding material 104 joins the Cu electrode 103 and the semiconductor element 102 so as to manufacture the bonded structure 106.

The bonding material 104 will be described below.

As has been discussed, the Ag layer 201 serving as a surface-treated layer of the Cu electrode 103 is diffused into Bi while the Bi layer 203 melts and solidifies in FIGS. 2B and 2C.

Bi of the Bi layer 203 forms a two-component eutectic crystal of Ag and <Bi - 3.5 wt%Ag>. Thus, the melting point of the bonding material 104 is 262°C after Ag is diffused to Bi.

The Ag layer 201 is formed as a surface-treated layer of the Cu electrode 103 in order to obtain the wettability of molten Bi over the bottom of the semiconductor element 102.

The second intermediate layer 206 and the first intermediate layer 207 will be described below.

First, the second intermediate layer 206 is a layer formed by a diffusion reaction in the electrode surface-treated layer 202 in a heated state at 320°C or a diffusion reaction of the electrode surface-treated layer 202 and Cu of the Cu electrode 103.

Similarly, the first intermediate layer 207 is a layer formed by a diffusion reaction in the Bi underlying layer 205 in a heated state at 320°C or a diffusion reaction of Cu at the bottom of the barrier metal layer 204 and the Bi underlying layer 205.

The bonded structure 106 is configured such that the Cu electrode 103 and Cu on the surface of the semiconductor element 102 are joined to each other via the three-layer laminated body 209a including the second intermediate layer 206, the bonding material 104, and the first intermediate layer 207. For stress relaxation in a bonded section 208, Young's moduli need to be sequentially increased, that is, progressively toward the bonding material 104, the second intermediate layer 206, and the Cu electrode 103 or toward the bonding material 104, the first intermediate layer 207, and the semiconductor element 102.

This configuration is obtained by setting the Young's modulus of the first intermediate layer 207 between the Young's modulus of the bonding material 104 and a Young's modulus on the surface of the semiconductor element 102, that is, at an intermediate value between the Young's moduli while setting the Young's modulus of the second intermediate layer 206 between the Young's modulus of the bonding material 104 and the Young's modulus of the Cu electrode 103, that is, at an intermediate value between the Young's moduli.

The three-layer laminated body 209a will be specifically described below.

The laminated body 209a is configured for the semiconductor element 102 and the Cu electrode 103 so as to satisfy the following conditions (p) and (q):

$$E3 < E21 < E1 \ \ldots \ (p)$$

$$E3 < E24 < E4 \ \ldots \ (q)$$

where E21 is a Young's modulus obtained on one surface of the first intermediate layer 207 so as to face the semiconductor element 102 and E24 is a Young's modulus obtained on one surface of the second intermediate layer 206 so as to face the Cu electrode 103. In this case, E1 is the Young's modulus of Cu on the surface of the semiconductor element 102, E3 is the Young's modulus of the bonding material 104, and E4 is the Young's modulus of the Cu electrode 103.

In this case, the Young's modulus of the intermediate layer has an intermediate value. For example, in the case of the first intermediate layer 207 near the semiconductor element 102, the intermediate value means not only a numeric value close to a median value between the Young's modulus E3 of the bonding material 104 and the Young's modulus of the bottom layer (Cu) of the barrier metal layer 204 on the semiconductor element 102 but also the Young's modulus of the bottom layer (Cu) of the barrier metal layer 204 or a numeric value close to the Young's modulus of the bonding material, that is, a numeric value deviated from the median value to one of the Young's moduli. The former example will be described in Example 1 while the latter example will be described in Example 3.

As has been discussed in the inventions described in the third and fourth embodiments, a stress can be relaxed by disposing the two-layer laminated body between the semiconductor element and the electrode.

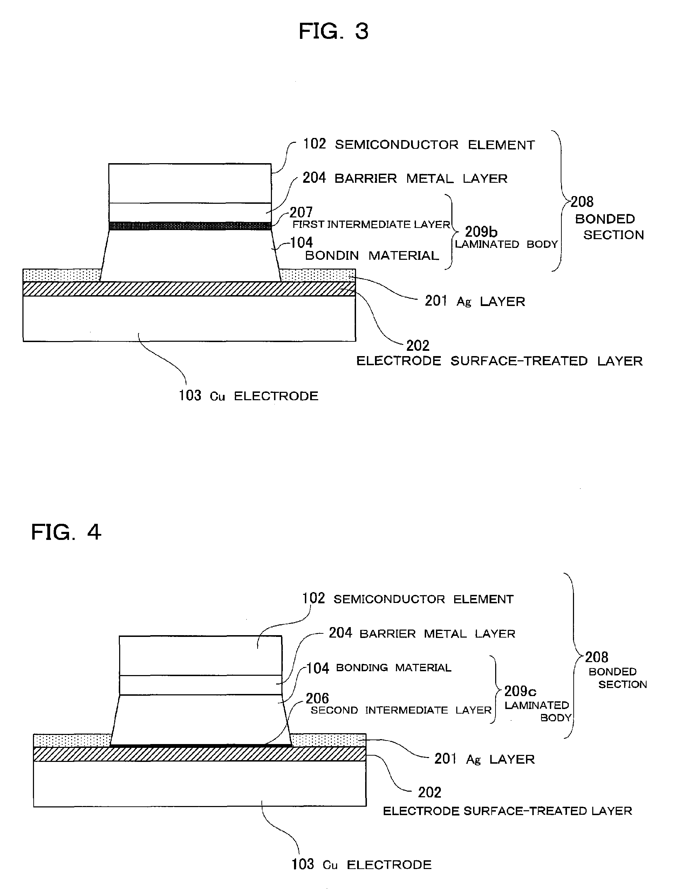

Fig. 3 shows a bonded structure including a two-layer laminated body according to the invention described in the third embodiment.

The intermediate layer of a laminated body is formed on one surface of the bonding material 104 and near the semiconductor element 102. The laminated body 209b does not include an intermediate layer disposed on one surface of the bonding material 104 and near the Cu electrode 103.

The Cu electrode 103 and Cu on the surface of the semiconductor element 102 are joined to each other via the two-layer laminated body 209b composed of the bonding material 104 and the first intermediate layer 207, and the Young's modulus of the first intermediate layer 207 is set between the Young's modulus of the bonding material 104 and the Young's modulus of the bottom layer (Cu) of the barrier metal layer 204 on the semiconductor element 102. Thus, the Young's moduli of the two-layer laminated body 209b composed of the bonding material 104 and the first intermediate layer 207 are sequentially increased toward the bonding material 104, the first intermediate layer 207, and the bottom layer (Cu) of the barrier metal layer on the semiconductor element 102.

This point will be described below based on the invention according to the third embodiment, which relates to the two-layer laminated body including the intermediate layer disposed on one surface of the bonding material 104 and near the semiconductor element. The two-layer laminated body 209b will be more specifically explained below.

The two-layer laminated body 209b is configured between the semiconductor element 102 and the Cu electrode 103 so as to satisfy the following condition (p) :

$$E3 < E21 < E1 \ ... \ (p)$$

where E21 is the Young's modulus of the first intermediate layer 207 near the semiconductor element 102, E1 is the Young's modulus of Cu on the surface of the semiconductor element 102, and E3 is the Young's modulus of the bonding material 104.

FIG. 4 illustrates a bonded structure according to the invention described in the fourth embodiment. The laminated body has a different two-layer structure.

In FIG. 4, the intermediate layer of the laminated body is formed on one surface of the bonding material 104 and near the Cu electrode 103. The laminated body 209c does not include an intermediate layer disposed on the bonding material 104 near the semiconductor element 102.

The Cu electrode 103 and Cu on the surface of the semiconductor element 102 are joined to each other via the two-layer laminated body 209c composed of the bonding material 104 and the second intermediate layer 206, and the Young's modulus of the second intermediate layer 206 is set between the Young's modulus of the bonding material 104 and the Young's modulus of the Cu electrode 103. Thus, the Young's moduli of the two-layer laminated body 209c composed of the bonding material 104 and the second intermediate layer 206 are sequentially increased toward the bonding material 104, the second intermediate layer 206, and the Cu electrode 103.

The two-layer laminated body 209c will be more specifically described below.

The two-layer laminated body 209c is configured between the semiconductor element 102 and the Cu electrode 103 so as to satisfy the following condition (q) :

$$E3 < E24 < E4 \ ... \ (q)$$

where E24 is the Young's modulus of the second intermediate layer 206 that faces the electrode. In this case, E3 is the Young's modulus of the bonding material 104 and E4 is the Young's modulus of the Cu electrode 103.

In the fabrication of the bonded structure 106, as shown in FIG. 3 or 4, a spring effect can be exerted by forming the intermediate layer only on one surface of the bonding material 104 so as to obtain the two-layer laminated bodies 209b and 209c. As shown in FIG. 2C, the spring effect is more preferably exerted by forming the intermediate layers on the top and bottom of the bonding material 104 so as to obtain the three-layer laminated body 209a.

The material of the intermediate layer is preferably selected from the group consisting of an AuSn compound, an AgSn compound, a CuSn compound, Au, and Ag. A more preferable material is a CuSn compound.

Furthermore, the thickness of the intermediate layer will be described below with reference to an example of an Au/Sn configuration.

The Au/Sn configuration before bonding reacts to form an AuSn compound after the bonding. This reaction is expressed by equation (a) below:

$$Au + 4Sn \rightarrow AuSn_4 \quad \ldots \quad (a)$$

When $L_{Au}$ is the thickness of Au before bonding and $L_{Sn}$ is the thickness of Sn before bonding, the relationship is stoichiometrically expressed by equation (b) below:

$$L_{Sn} = 4 \times L_{Au} \times \rho_{Au} \times M_{Sn}/\rho_{Sn} \times M_{Au} \quad \ldots \quad (b)$$

where $\rho$ is a density, M is an atomic weight, and subscripts indicate elements.

For example, according to Example 1 which will be discussed later, physical properties are substituted into equation (b) when Au is deposited with a thickness of 0.1 $\mu$m. Accordingly, Sn has a thickness of 0.6 $\mu$m or more before bonding. Hence, if the thickness of Sn is smaller than 0.6 $\mu$m before bonding, only the intermetallic compound of equation (a) is generated after the bonding. Sn is totally lost in a Sn film before the bonding.

In Example 1, Sn was deposited with a thickness of 0.3 $\mu$m, which is quite smaller than 0.6 $\mu$m, so as to reliably form only the intermetallic compound in consideration of variations in plating deposition.

Thus, even if the thickness of Au is not 0.1 $\mu$m, the thickness of Sn before bonding may be properly set based on the design idea without leaving a single Sn layer after the bonding.

If a single Sn layer is left after the bonding, a phase is formed at 232°C, which is the melting point of Sn, in the bonded section 208 and thus Sn may be melted again during packaging on the substrate 101 of the power semiconductor module 100. For this reason, a single Sn layer is not left after bonding.

The Au/Sn configuration was described in the explanation. Likewise, the thicknesses of Ag/Sn, Sn, Au, and Ag may be considered according to the standards of Ag/Sn, Sn, Au, and Ag.

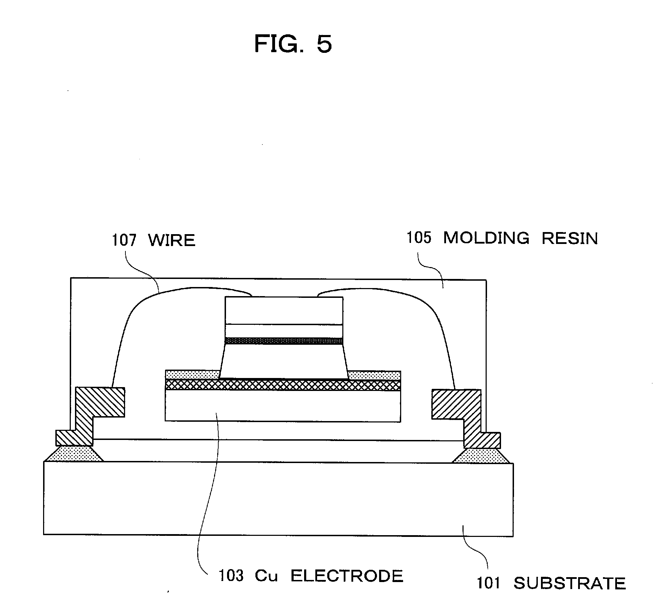

As has been discussed, after the completion of the bonded structure 106, the power semiconductor module 100 is fabricated using the bonded structure 106 as illustrated in FIG. 1, and then the semiconductor module 100 is mounted on the substrate 101 with the solder material 109 to fabricate the mounting structure 110 (see FIG. 5).

The solder material 109 for packaging is typically Sn-3wt%Ag-0.5wt%Cu (melting at 217°C). Any solder materials are applicable as long as the materials are lead-free Sn solder materials. For example, the solder material 109 may be Sn-0.7wt%Cu (melting at 227°C), Sn-3.5wt%Ag-0.5wt%Bi-6.0wt%In (melting at 220°C), and so on.

- Examples -

The following will describe an example of the bonded structure that is the invention described in the embodiment, an example of the fabrication of the mounting structure in which the power semiconductor module obtained by the bonded structure is mounted on the substrate, and an evaluation test example of the yield of the mounting structure.

<Example of the bonded structure>

In Examples 1 to 15, the first and second intermediate layers 207 and 206 in Examples 1 to 5 were formed on the respective top and bottom of the bonding material 104 as described above. In Examples 6 to 10, only the first intermediate layer 207 was formed on one surface of the bonding material 104 and near the semiconductor element 102. In Examples 11 to 15, only the second intermediate layer 206 was formed on one surface of the bonding material 104 and near the Cu electrode 103.

In Comparative Example 1 according to the related art, the electrode surface-treated layer 202 and the Bi underlying layer 205 are not provided and the first and second intermediate layers 207 and 206 obtained by heating and diffusion are not formed.

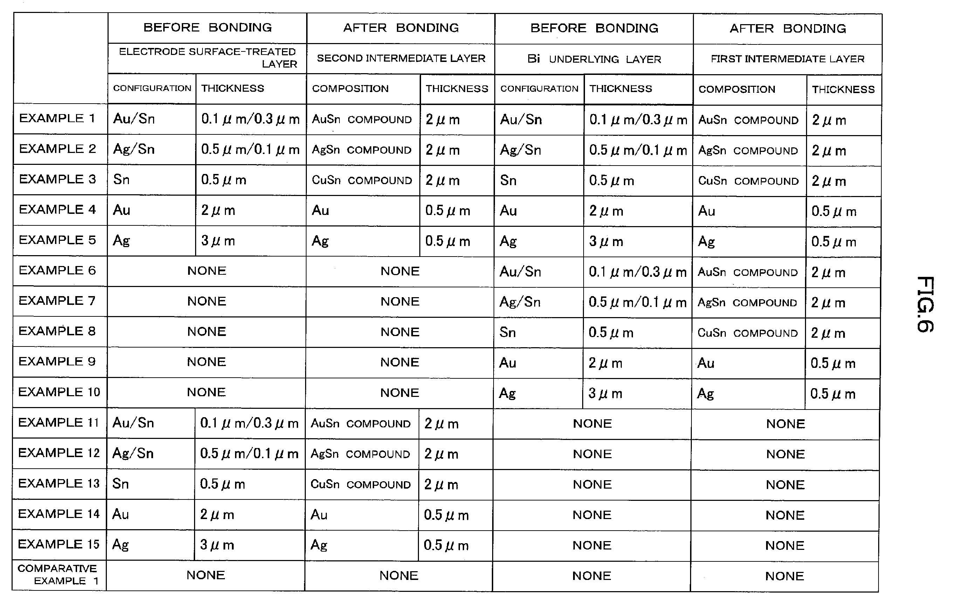

FIG. 6 shows the configurations and thicknesses of the electrode surface-treated layer 202 and the Bi underlying layer 205 before bonding and the compositions and thicknesses of the second intermediate layer 206 and the first intermediate layer 207 after the bonding according to Examples 1 to 15.

(1) Example 1

As shown in FIG. 6, the electrode surface-treated layer 202 had two layers of 0.1-$\mu$m Au/0.3-$\mu$m Sn. In this case, one side far from the Bi layer 203 contains Au while the other side near the Bi layer 203 contains Sn.

Similarly, the Bi underlying layer 205 had two stacked layers of 0.1-$\mu$m Au/0.3-$\mu$m Sn. In this case, one side far from the Bi layer 203 contains Au while the other side near the Bi layer 203 contains Sn.

Subsequently, the electrode surface-treated layer 202 was heated to 320°C so as to generate an intermetallic compound through a diffusion reaction in the electrode surface-treated layer 202. This formed the second intermediate layer 206 containing an AuSn compound of 2 $\mu$m. Similarly, an intermetallic compound was generated by a diffusion reaction in the Bi underlying layer 205, forming the first intermediate layer 207 containing an AuSn compound of 2 $\mu$m.

It was confirmed that the AuSn compound was AuSn4 (the atomic weight ratio of Au to Sn was 1 to 4) by energy dispersive X-ray spectroscopy.

(2) Example 2

As shown in FIG. 6, the electrode surface-treated layer 202 had two stacked layers of 0.5-$\mu$m Ag/0.1-$\mu$m Sn and the Bi underlying layer 205 had two stacked layers of 0.5-$\mu$m Ag/0.1-$\mu$m Sn. In this case, one side far from the Bi layer 203 contains Ag while the other side near the Bi layer 203 contains Sn.

Subsequently, the electrode surface-treated layer 202 was heated to 320°C so as to form the second intermediate layer 206, which contains an AgSn compound of 2 $\mu$m, through a diffusion reaction in the electrode surface-treated layer 202. Similarly, the first intermediate layer 207 containing an AgSn compound of 2 $\mu$m was formed by a diffusion reaction in the Bi underlying layer 205.

It was confirmed that the AgSn compound was Ag3Sn (the atomic weight ratio of Ag to Sn was 3 to 1) by energy dispersive X-ray spectroscopy.

(3) Example 3

As shown in FIG. 6, the electrode surface-treated layer 202 was a single layer of 0.5-$\mu$m Sn while the Bi underlying layer 205 was a single layer of 0.5-$\mu$m Sn.

Subsequently, the electrode surface-treated layer 202 was heated to 320°C so as to form the second intermediate layer 206, which contains a CuSn compound of 2 $\mu$m, through a diffusion reaction in the electrode surface-treated layer 202 and the Cu electrode 103. Similarly, the first intermediate layer 207 containing a CuSn compound of 2 $\mu$m was formed by a diffusion reaction in the Bi underlying layer 205 and Cu at the bottom of the barrier metal layer 204.

It was confirmed that the CuSn compound was Cu6Sn5 (the atomic weight ratio of Cu to Sn was 6 to 5) by energy dispersive X-ray spectroscopy.

(4) Example 4

As shown in FIG. 6, the electrode surface-treated layer 202 was a single layer of 2-$\mu$m Au while the Bi underlying layer 205 was a single layer of 2-$\mu$m Au.

Subsequently, the electrode surface-treated layer 202 was heated to 320°C so as to form the second intermediate layer 206, which contains Au of 0.5 $\mu$m, through a diffusion reaction in the electrode surface-treated layer 202. Similarly, the first intermediate layer 207 containing Au of 0.5 $\mu$m was formed by a diffusion reaction in the Bi underlying layer 205. In this case, Au does not form an intermetallic compound with the electrode or Cu of the bottom layer of the barrier metal layer 204.

(5) Example 5

As shown in FIG. 6, the electrode surface-treated layer 202 was a single layer of 2-$\mu$m Ag while the Bi underlying layer 205 was a single layer of 2-$\mu$m Ag.

Subsequently, the electrode surface-treated layer 202 was heated to 320°C so as to form the second intermediate layer 206, which contains Ag of 0.5 $\mu$m, through a diffusion reaction in the electrode surface-treated layer 202. Similarly, the first intermediate layer 207 containing Ag of 0.5 $\mu$m was formed by a diffusion reaction in the Bi underlying layer 205. In this case, Ag does not form an intermetallic compound with the electrode or Cu of the bottom layer of the barrier metal layer 204.

(6) Examples 6 to 10

The Bi underlying layer 205 including at least one layer was formed with a configuration and a thickness in FIG. 6. After that, the Bi underlying layer 205 was heated to 320°C to form the first intermediate layer 207 with a composition and a thickness in FIG. 6. The second intermediate layer 206 was not formed.

(7) Examples 11 to 15

The electrode surface-treated layer 202 including at least one layer was formed with a configuration and a thickness in FIG. 6. After that, the electrode surface-treated layer 202 was heated to 320°C to form the second intermediate layer 206 with a composition and a thickness in FIG. 6. The first intermediate layer 207 was not formed.

<Example of fabrication of the mounting structure>

As shown in FIG. 5, the completed bonded structure 106 according to the examples was used to perform wire bonding (or ribbon bonding) with wires 107. The bonded structure was molded to form the power semiconductor module 100, and then the power semiconductor module 100 was mounted on the substrate 101 with a solder material, forming the mounting structure 110.

As has been discussed, the solder material 109 was Sn-3wt%Ag-0.5wt%Cu (melting at 217°C) that is a typical solder material.

The product yield of the mounting structure 110 will be evaluated below.

<Yield evaluation test example of the mounting structure>

The low temperature was fixed at -65°C and the high temperature was set at three steps of 150°C, 175°C, and 200°C to repeat 300 cycles of a low temperature-high temperature cycle test (30 minutes per cycle/30 minutes). After that, a product was observed by ultrasonic imaging so as to visually check the presence or absence of cracks and peeling of the bonding material of the bonded structure. A product yield (N = 20) with cracks or peeling less than 20% was calculated relative to the surface area of the bonded section, and then the quality of the product was evaluated according to the following standards:

Good: yield of at least 80% (non-defective)

Poor: yield of less than 80% (defective)

<Yield test evaluation>

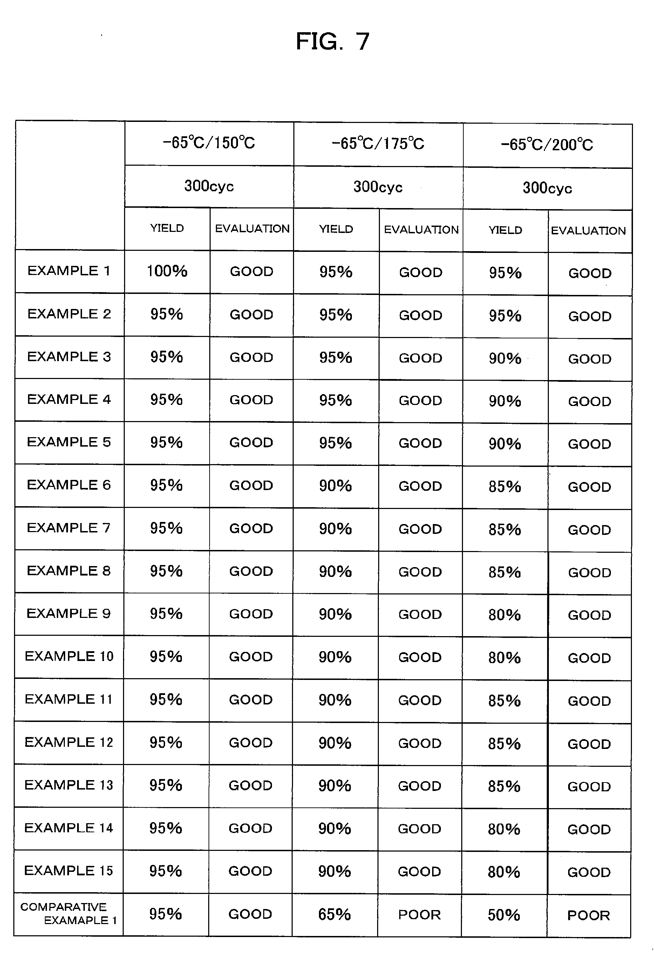

FIG. 7 shows yield test results.

First, in Examples 1 to 15, at any one of the high temperatures of 150°C, 175°C, and 200°C in temperature cycle test conditions, the yield was at least 80% and thus the product was judged to be non-defective (good).

In contrast, in Comparative Example 1, at a high temperature of 150°C in the temperature cycle test conditions, the yield was 95%. At higher temperatures of 175°C and 200°C, the yield decreased to 65% and 50%, and thus the product was judged to be defective (poor).

Generally, in a temperature cycle test, a large temperature difference $\Delta T$ between the high temperature and the low temperature increases a thermal stress based on a difference between the thermal expansion coefficient of the semiconductor element 102 ($\alpha \approx 3$ ppm/K) and the linear expansion coefficient of Cu that is a material of the Cu electrode 103 ($\alpha \approx 18$ ppm/K). The stress is applied to the bonded section 208 of the bonded structure.

In Comparative Example 1 (related art), it is understood that the product is resistant to a thermal stress at a high temperature of 150°C but is not resistant to a thermal stress at 175°C and 200°C.

In contrast, the product was judged to be non-defective in all Examples 1 to 15 of the present invention.

The reason why the examples are superior to Comparative Example 1 will be examined below. Example 1 will be discussed as a representative example.

First, the Young's moduli of the configurations of the bonded sections will be examined. The configuration of Comparative Example 1 has a three-layer structure of the Cu electrode 103, the Bi layer 203 (bonding material) including the diffused Ag layer, and the Cu layer at the bottom of the barrier metal layer 204, and thus the Young's moduli are $Cu(110 \times 10^9 N/m^2)/Bi-3.5wt\%Ag(32 \times 10^9 N/m^2)/Cu(110 \times 10^9 N/m^2)$.

In the configuration of Example 1, the first and second intermediate layers 207 and 206 are stacked on the top and bottom of the Bi layer 203 (bonding material) including the diffused Ag layer, and thus the Young's moduli are $Cu(110 \times 10^9 N/m^2)/AuSn4(55.6 \times 10^9 N/m^2))/Bi-3.5wt\%Ag(32 \times 10^9 N/m^2)/AuSn4(55.6 \times 10^9 N/m^2))/Cu(110 \times 10^9 N/m^2)$.

As expressed in equation (c), a Young's modulus is the ratio of a stress and a strain for an elastic action of a material.

$$E = \sigma/\varepsilon \quad \ldots \quad (c)$$

In equation (c), E is a Young's modulus, $\sigma$ is a stress, and $\varepsilon$ is a strain.

A Young's modulus and a strain amount are inversely proportional to each other. Thus, if a constant stress is applied, a strain amount increases as a Young's modulus decreases.

Hence, Comparative Example 1 and Example 1 are distinguished from each other by the presence or absence of an AuSn compound (AuSn4) of the intermediate layer between the Cu layer and the Bi-3.5wt% Ag layer. In Example 1, the intermediate layer is provided from the bonding material of Bi-3.5wt%Ag to Cu, progressively increasing the Young's modulus. This exerts the spring effect with a stress relaxing function.

In Comparative Example 1, however, a Young's modulus does not progressively increase. A large difference in Young's modulus between the bonding material and the electrode or the barrier metal layer does not exert a so-called spring effect. It can be estimated that such a large difference in Young's modulus causes the superiority of Example 1 over Comparative Example 1, that is, a difference in yield under high-temperature conditions.

The intermediate layers of other Examples 2 to 15 have a similar effect:

The intermediate layer (Ag3Sn) of samples 2, 7, and 12 :Young's modulus = $74.5 \times 10^9 N/m^2$
The intermediate layer (Cu6Sn5) of samples 3, 8, and 13 :Young's modulus = $93.5 \times 10^9 N/m^2$
The intermediate layer (Au) of samples 4, 9, and 14 :Young's modulus = $80 \times 10^9 N/m^2$
The intermediate layer (Ag) of samples 5, 10, and 15 :Young's modulus = $76 \times 10^9 N/m^2$

It can be estimated that the intermediate layer disposed between Cu and Bi-3.5wt%Ag exerts the spring effect with the stress relaxing function.

The test results of Examples 1 to 15 will be specifically examined below.

Examples 1 to 5 provided with the first and second intermediate layers 207 and 206 on the two surfaces of the bonding material 104 were compared with Examples 6 to 10 provided with only the first intermediate layer 207 and Examples 11 to 15 provided with only the second intermediate layer 206. This proves that a difference in yield is 10% to 15% in FIG. 7 and Examples 1 to 5 provided with the intermediate layers on the two surfaces are superior in yield to the other examples.

Thus, the stress relaxing function is effectively exerted even if the intermediate layer is provided only on one surface of the bonding material 104, near the semiconductor element 102 or the Cu electrode 103. In order to further exert the stress relaxing function, the intermediate layers are desirably provided on the two surfaces of the bonding material 104 and near the semiconductor element 102 and the Cu electrode 103.

In Examples 4 and 5, Examples 9 and 10, and Examples 14 and 15, the thickness of the intermediate layer after bonding is considerably reduced to 0.5 $\mu$m from that of Au and the Ag layer before bonding. This is because the intermediate layer is diffused into Bi-3.5wt%Ag near the electrode surface-treated layer and the Bi underlying layer before bonding. The yield tests prove that the desired spring effect can effectively obtain the stress relaxing function also in this configuration.

A feature of the present invention is to progressively increase a Young's modulus from the laminated body to the semiconductor element or the electrode. For example, the first intermediate layer 207 (AuSn4) of Example 1 has a Young's modulus of $55.6 \times 10^9 N/m^2$, which is substantially a median value between the Young's modulus ($110 \times 10^9 N/m^2$) of the Cu layer at the bottom of the barrier metal layer 204 and the Young's modulus ($32 \times 10^9 N/m^2$) of the bonding material (Bi-3.5wt%Ag). In Example 3, the first intermediate layer 207 (Cu6Sn5) has a Young's modulus of $93.5 \times 10^9 N/m^2$, which is close to the Young's modulus ($110 \times 10^9 N/m^2$) of the Cu layer of the barrier metal layer 204.

Thus, even if the Young's moduli of the first and second intermediate layers 207 and 206 are close to that of the surface of the semiconductor element, that is, that of Cu under the barrier metal layer or the electrode Cu, the spring effect can be exerted according to the test results. The Young's moduli of the first and second intermediate layers 207 and 206 may not be set at a numeric value around the median value as long as the Young's moduli are set between that of Cu on the surface of the semiconductor element and that of the Cu electrode.

Industrial Applicability

In a mounting structure including a bonded structure according to the present invention, a semiconductor element and a Cu electrode are bonded to each other via a laminated structure that progressively increases a Young's modulus from a bonding material to a bonded material (the semiconductor element, the Cu electrode), achieving stress relaxation against a thermal stress generated in a temperature cycle during the use of a power semiconductor module. The present invention is applicable to the use of a semiconductor package including the power semiconductor module and a low-power transistor.

**Claims**

1. A bonded structure comprising a semiconductor element bonded to a Cu electrode with a bonding material predominantly composed of Bi,
wherein the bonding material and an intermediate layer formed on a surface of the bonding material constitute a laminated body, Cu on a surface of the semiconductor element is bonded to the Cu electrode via the laminated body, and
the laminated body is configured for the semiconductor element and the Cu electrode such that Young's moduli E1 to E4 satisfy at least one of following conditions (p1) and (q1) :

$$E3 < E2 < E1 \ldots (p1)$$

$$E3 < E2 < E4 \ldots (q1)$$

where E1 is the Young's modulus of Cu on the surface of the semiconductor element, E2 is the Young's modulus of the intermediate layer, E3 is the Young's modulus of the bonding material, and E4 is the Young's modulus of the Cu electrode.

2. The bonded structure according to claim 1, wherein the laminated body is a three-layer laminated body including the bonding material and two intermediate layers formed on top and bottom of the bonding material, and the three-layer laminated body is configured for the semiconductor element and the Cu electrode such that the Young's moduli E1, E3, and E4 and Young's moduli E21 and E24 satisfy at least one of following conditions (p2) and (q2) :

$$E3 < E21 < E1 \ldots (p2)$$

$$E3 < E24 < E4 \ldots (q2)$$

where E21 is the Young's modulus of the first intermediate layer near the semiconductor element and E24 is the Young's modulus of the second intermediate layer near the Cu electrode.

3. The bonded structure according to claim 1, wherein the laminated body is a two-layer laminated body including the bonding material and an intermediate layer formed on the bonding material and near the semiconductor element, and the two-layer laminated body is configured for the semiconductor element and the Cu electrode such that the Young's moduli E1 and E3 and a Young's modulus E21 satisfy a following condition (p2):

$$E3 < E21 < E1 \ldots (p2)$$

where E21 is the Young's modulus of the intermediate layer.

4. The bonded structure according to claim 1, wherein the laminated body is a two-layer laminated body including the bonding material and an intermediate layer formed on the bonding material and near the Cu electrode, and the two-layer laminated body is configured for the semiconductor element and the Cu electrode such that the Young's moduli E3 and E4 and a Young's modulus E24 satisfy a following condition (q2):

$$E3 < E24 < E4 \ldots (q2)$$

where E24 is the Young's modulus of the intermediate layer.

5. The bonded structure according to any one of claims 1 to 4, wherein the intermediate layer is made of at least one metal selected from the group consisting of an AuSn compound, an AgSn compound, a CuSn compound, Au, and Ag.

6. The bonded structure according to any one of claims 1 to 5, wherein the intermediate layer is made of a CuSn compound.

# FIG. 1

110 MOUNTING STRUCTURE

100 POWER SEMICONDUCTOR MODULE

SEMICONDUCTOR ELEMENT
102

106
BONDED STRUCTUR

105 MOLDING RESIN

109
SOLDER MATERIAL

WIRE 107

104
BONDING MATERIAL

103
Cu ELECTRODE

101
SUBSTRATE

## FIG. 2A

201 Ag LAYER

202
ELECTRODE SURFACE-TREATED LAYER

103 Cu ELECTRODE

## FIG. 2B

102 SEMICONDUCTOR ELEMENT

204 BARRIER METAL LAYER

205 Bi UNDERLYING LAYER

203 Bi LAYER

201 Ag LAYER

202
ELECTRODE SURFACE-TREATED LAYER

103 Cu ELECTRODE

## FIG. 2C

102 SEMICONDUCTOR ELEMENT

204 BARRIER METAL LAYER

207 FIRST INTERMEDIATE LAYER

104 BONDING MATERIAL

206
SECOND INTERMEDIATE LAYER

209a
LAMINATED
BODY

208
BONDED
SECTION

201 Ag LAYER

202
ELECTRODE SURFACE-TREATED LAYER

103 Cu ELECOTRODE

## FIG. 3

102 SEMICONDUCTOR ELEMENT

204 BARRIER METAL LAYER

207
FIRST INTERMEDIATE LAYER

104
BONDIN MATERIAL

209b
LAMINATED BODY

208
BONDED
SECTION

201 Ag LAYER

202
ELECTRODE SURFACE-TREATED LAYER

103 Cu ELECTRODE

## FIG. 4

102 SEMICONDUCTOR ELEMENT

204 BARRIER METAL LAYER

104 BONDING MATERIAL

206
SECOND INTERMEDIATE LAYER

209c
LAMINATED
BODY

208
BONDED
SECTION

201 Ag LAYER

202
ELECTRODE SURFACE-TREATED LAYER

103 Cu ELECTRODE

16

# FIG. 5

107 WIRE    105 MOLDING RESIN

103 Cu ELECTRODE    101 SUBSTRATE

17

FIG.6

| | BEFORE BONDING | | AFTER BONDING | | BEFORE BONDING | | AFTER BONDING | |
|---|---|---|---|---|---|---|---|---|
| | ELECTRODE SURFACE-TREATED LAYER | | SECOND INTERMEDIATE LAYER | | Bi UNDERLYING LAYER | | FIRST INTERMEDIATE LAYER | |
| | CONFIGURATION | THICKNESS | COMPOSITION | THICKNESS | CONFIGURATION | THICKNESS | COMPOSITION | THICKNESS |
| EXAMPLE 1 | Au/Sn | $0.1\,\mu$m/$0.3\,\mu$m | AuSn COMPOUND | $2\,\mu$m | Au/Sn | $0.1\,\mu$m/$0.3\,\mu$m | AuSn COMPOUND | $2\,\mu$m |
| EXAMPLE 2 | Ag/Sn | $0.5\,\mu$m/$0.1\,\mu$m | AgSn COMPOUND | $2\,\mu$m | Ag/Sn | $0.5\,\mu$m/$0.1\,\mu$m | AgSn COMPOUND | $2\,\mu$m |
| EXAMPLE 3 | Sn | $0.5\,\mu$m | CuSn COMPOUND | $2\,\mu$m | Sn | $0.5\,\mu$m | CuSn COMPOUND | $2\,\mu$m |
| EXAMPLE 4 | Au | $2\,\mu$m | Au | $0.5\,\mu$m | Au | $2\,\mu$m | Au | $0.5\,\mu$m |
| EXAMPLE 5 | Ag | $3\,\mu$m | Ag | $0.5\,\mu$m | Ag | $3\,\mu$m | Ag | $0.5\,\mu$m |
| EXAMPLE 6 | NONE | | NONE | | Au/Sn | $0.1\,\mu$m/$0.3\,\mu$m | AuSn COMPOUND | $2\,\mu$m |
| EXAMPLE 7 | NONE | | NONE | | Ag/Sn | $0.5\,\mu$m/$0.1\,\mu$m | AgSn COMPOUND | $2\,\mu$m |
| EXAMPLE 8 | NONE | | NONE | | Sn | $0.5\,\mu$m | CuSn COMPOUND | $2\,\mu$m |
| EXAMPLE 9 | NONE | | NONE | | Au | $2\,\mu$m | Au | $0.5\,\mu$m |
| EXAMPLE 10 | NONE | | NONE | | Ag | $3\,\mu$m | Ag | $0.5\,\mu$m |
| EXAMPLE 11 | Au/Sn | $0.1\,\mu$m/$0.3\,\mu$m | AuSn COMPOUND | $2\,\mu$m | NONE | | NONE | |
| EXAMPLE 12 | Ag/Sn | $0.5\,\mu$m/$0.1\,\mu$m | AgSn COMPOUND | $2\,\mu$m | NONE | | NONE | |
| EXAMPLE 13 | Sn | $0.5\,\mu$m | CuSn COMPOUND | $2\,\mu$m | NONE | | NONE | |
| EXAMPLE 14 | Au | $2\,\mu$m | Au | $0.5\,\mu$m | NONE | | NONE | |
| EXAMPLE 15 | Ag | $3\,\mu$m | Ag | $0.5\,\mu$m | NONE | | NONE | |
| COMPARATIVE EXAMPLE 1 | NONE | | NONE | | NONE | | NONE | |

# FIG. 7

| | -65°C/150°C | | -65°C/175°C | | -65°C/200°C | |
|---|---|---|---|---|---|---|
| | 300cyc | | 300cyc | | 300cyc | |
| | YIELD | EVALUATION | YIELD | EVALUATION | YIELD | EVALUATION |
| EXAMPLE 1 | 100% | GOOD | 95% | GOOD | 95% | GOOD |
| EXAMPLE 2 | 95% | GOOD | 95% | GOOD | 95% | GOOD |
| EXAMPLE 3 | 95% | GOOD | 95% | GOOD | 90% | GOOD |
| EXAMPLE 4 | 95% | GOOD | 95% | GOOD | 90% | GOOD |
| EXAMPLE 5 | 95% | GOOD | 95% | GOOD | 90% | GOOD |
| EXAMPLE 6 | 95% | GOOD | 90% | GOOD | 85% | GOOD |
| EXAMPLE 7 | 95% | GOOD | 90% | GOOD | 85% | GOOD |
| EXAMPLE 8 | 95% | GOOD | 90% | GOOD | 85% | GOOD |
| EXAMPLE 9 | 95% | GOOD | 90% | GOOD | 80% | GOOD |
| EXAMPLE 10 | 95% | GOOD | 90% | GOOD | 80% | GOOD |
| EXAMPLE 11 | 95% | GOOD | 90% | GOOD | 85% | GOOD |
| EXAMPLE 12 | 95% | GOOD | 90% | GOOD | 85% | GOOD |
| EXAMPLE 13 | 95% | GOOD | 90% | GOOD | 85% | GOOD |
| EXAMPLE 14 | 95% | GOOD | 90% | GOOD | 80% | GOOD |
| EXAMPLE 15 | 95% | GOOD | 90% | GOOD | 80% | GOOD |
| COMPARATIVE EXAMAPLE 1 | 95% | GOOD | 65% | POOR | 50% | POOR |

# FIG. 8

## PRIOR ART

402
POWER SEMICONDUCTOR ELEMENT

401
POWER SEMICONDUCTOR MODULE

408 WIRE

405 RESIN

406
SOLDER MATERIAL

407 SUBSTRATE

403 ELECTRODE

404 BONDED SECTION

<table>
<tr><td colspan="2" align="center">**INTERNATIONAL SEARCH REPORT**</td><td>International application No.<br>PCT/JP2012/003318</td></tr>
</table>

A. CLASSIFICATION OF SUBJECT MATTER
*H01L21/52*(2006.01)i, *B23K1/00*(2006.01)i, *B23K1/20*(2006.01)i, *B23K35/14*
(2006.01)i, *B23K35/26*(2006.01)i, *C22C12/00*(2006.01)i, *H01L23/34*(2006.01)i

According to International Patent Classification (IPC) or to both national classification and IPC

B. FIELDS SEARCHED

Minimum documentation searched (classification system followed by classification symbols)
H01L21/52, B23K1/00, B23K1/20, B23K35/14, B23K35/26, C22C12/00, H01L23/34

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2011-071152 A (Panasonic Corp.),<br>07 April 2011 (07.04.2011),<br>paragraphs [0037] to [0038], [0061] to [0065];<br>fig. 5<br>& WO 2011/036829 A1 | 1,4,5<br>2,3,6 |
| X<br>A | WO 2009/157130 A1 (Panasonic Corp.),<br>30 December 2009 (30.12.2009),<br>paragraphs [0030] to [0055]; fig. 1 to 3<br>& US 2010/0301481 A1 & CN 102017107 A | 1-5<br>6 |
| A | JP 2009-147111 A (Fuji Electric Device<br>Technology Co., Ltd.),<br>02 July 2009 (02.07.2009),<br>paragraphs [0025] to [0036]; fig. 1 to 3<br>(Family: none) | 6 |

☒ Further documents are listed in the continuation of Box C. ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>06 July, 2012 (06.07.12) | Date of mailing of the international search report<br>17 July, 2012 (17.07.12) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2012/003318

C (Continuation). DOCUMENTS CONSIDERED TO BE RELEVANT

| Category* | Citation of document, with indication, where appropriate, of the relevant passages | Relevant to claim No. |
|---|---|---|
| A | JP 2010-103206 A (Panasonic Corp.), 06 May 2010 (06.05.2010), paragraphs [0025] to [0050]; fig. 4 & US 2010/0148367 A1 & EP 2343734 A1 & WO 2010/047010 A1 & CN 101790780 A | 1-6 |
| A | JP 2011-003824 A (Panasonic Corp.), 06 January 2011 (06.01.2011), paragraphs [0012] to [0036]; fig. 2 (Family: none) | 1-6 |
| A | JP 2007-281412 A (Toyota Central Research and Development Laboratories, Inc.), 25 October 2007 (25.10.2007), paragraphs [0052] to [0064]; fig. 1 (Family: none) | 1-6 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006310507 A

- JP 2011023631 A